# FASCICULE DE BREVET EUROPEEN

(11) **EP 1 415 023 B1**
(45) Date de publication et mention de la délivrance du brevet: **20.08.2008**
(21) Numéro de dépôt: 02772489.7
(22) Date de dépôt: 06.08.2002
(51) Int. Cl.: C30B 29/48

(54) **PROCEDE D'OBTENTION D'UN MONOCRISTAL DE CDTE OU DE CDZNTE**
VERFAHREN ZUR HERSTELLUNG EINES EINKRISTALLES AUS CDTE ODER CDZNTE
METHOD OF OBTAINING A CDTE OR CDZNTE SINGLE CRYSTAL

(30) Priorité: 06.08.2001 FR 0110512
(43) Date de publication de la demande: 06.05.2004
(73) Titulaire: CENTRE NATIONAL DE LA RECHERCHE SCIENTIFIQUE (CNRS), 75794 Paris Cedex 16 (FR)
(72) Inventeur: TRIBOULET, Robert, Georges, Lucien, F-91190 Gif sur Yvette (FR); SAID HASSANI, Said, Assoumani, F-92140 Clamart (FR)
(74) Mandataire: Goulard, Sophie
(86) Numéro de dépôt international: PCT/FR2002/002816
(87) Numéro de publication internationale: WO 2003/014428

(56) Documents cités:
- EP-A- 1 013 801
- MOKRI A ET AL: "Growth of large, high purity, low cost uniform CdZnTe crystals by the "cold travelling heater method"" JOURNAL OF CRYSTAL GROWTH, NORTH-HOLLAND PUBLISHING CO. AMSTERDAM, NL, vol. 138, no. 1/4, 2 avril 1994 (1994-04-02), pages 168-174, XP000474526 ISSN: 0022-0248
- ZAPPETTINI A ET AL: "A new process for synthesizing high-purity stoichiometric cadmium telluride" JOURNAL OF CRYSTAL GROWTH, NORTH-HOLLAND PUBLISHING CO. AMSTERDAM, NL, vol. 214-215, juin 2000 (2000-06), pages 14-18, XP004200955 ISSN: 0022-0248
- ZHU S-F S-F ET AL: "Modified growth of Cd1-xZnxTe single crystals" JOURNAL OF CRYSTAL GROWTH, NORTH-HOLLAND PUBLISHING CO. AMSTERDAM, NL, vol. 208, no. 1-4, 1 janvier 2000 (2000-01-01), pages 264-268, XP004253405 ISSN: 0022-0248
- MELNIKOV A A ET AL: "Growth of CdZnTe single crystals for radiation detectors" JOURNAL OF CRYSTAL GROWTH, NORTH-HOLLAND PUBLISHING CO. AMSTERDAM, NL, vol. 197, no. 3, 15 février 1999 (1999-02-15), pages 666-669, XP004156440 ISSN: 0022-0248
- BRUNET ET AL: "Horizontal Bridgman growth of large high quality Cd1-yZnyTe crystals" MATERIALS SCIENCE AND ENGINEERING B, vol. b16, pages 44-47, XP008002737 LAUSANNE CH cité dans la demande
- JOY ET AL: 'electron channelling patterns in the scanning electron microscope' J. APPL.PHYS. vol. 53, no. 8, 1982, pages R81 - R121
- CHRISTIANSEN ET AL: 'Defect population and electrical properties of Ar+ laser recrystallised polycrystalline silicon thin films' MAT. RES. SOC. SYMP. PROC vol. 621, 2000, pages Q7.5.1 - Q7.5.8
- KORECKI ET AL: 'Holographic inversion of Kikuchi electron diffraction patterns for thin epitaxial NaCl films grown on GaAs (001)' SURFACE SCIENCE vol. 425, 1999, pages 22 - 30
- KOGURE: 'Identification of polytypic groups in hydrous phyllosilicates using electron back-scattering patterns' AMERICAN MINERALOGIST vol. 87, 2002, pages 1678 - 1685
- ATUCHIN ET AL: 'Structure and chemical composition of LiB3O5 surfaces' CRYST. RES. TECHNOL. vol. 38, no. 10, 2003, pages 896 - 902
- SCHWARZER: 'Measurement of macrotexture by automated crystal orientation mapping : an alternative to X-ray diffraction' MATERIALS SCIENCE AND TECHNOLOGY vol. 16, 2000, pages 1384 - 1388

## Description

La présente invention se rapporte au domaine de l'obtention de monocristaux de CdTe ou de CdZnTe. Elle est relative à un procédé amélioré pour l'obtention de cristaux de grande taille de CdZnTe ou de CdTe possédant une excellente structure cristalline.

Le tellure de cadmium ou CdTe, peut être considéré comme le représentant majeur de la famille des semi-conducteurs de type II-VI.

Depuis environ quarante années, le CdTe a suscité un intérêt considérable et trouvé de nombreuses applications industrielles. Il a donné lieu à plusieurs conférences internationales, et son histoire a été relatée dans la monographie de K.Zanio (Semiconductors and Semimetals, Vol. 13, Cadmium Telluride, Academic Press 1978). Le CdTe présente un ensemble unique de propriétés le rendant très approprié pour de nombreuses applications. Sa largeur de bande interdite de 1,5 eV, juste au centre du spectre solaire, en fait un matériau idéal pour la conversion photovoltaïque, et de nombreuses compagnies commercialisent des cellules solaires basées sur CdTe. Son numéro atomique moyen élevé de 50, sa forte largeur de bande interdite et ses bonnes propriétés de transport électrique sont adaptées pour la détection nucléaire. Son fort coefficient électro-optique combiné à son faible coefficient d'absorption autorisent la réalisation de modulateurs électro-optiques et de dispositifs photoréfractifs performants. CdTe présente les deux types de conductivité, n et p, permettant sa mise en oeuvre pour la fabrication de diodes et de transistors à effet de champ. Les semi-conducteurs semi-magnétiques, tels que CdMnTe, présentent aussi des propriétés avantageuses comme des rotations Faraday géantes les rendant très attractifs pour des isolateurs optiques.

Le CdTe est aussi utilisé au niveau industriel par l'entremise de son alliage ternaire CdHgTe, un des matériaux majeurs en détection infrarouge, et CdZnTe, qui est utilisé comme substrat pour le dépôt épitaxial de couches de HgCdTe et comme détecteur nucléaire, cette dernière application présentant un grand intérêt, particulièrement pour des utilisations médicales.

Deux applications dominent actuellement le développement industriel de CdTe :
- CdTe, et plus particulièrement son alliage avec 4% de zinc, est très largement utilisé comme substrat pour le dépôt épitaxial de couches de HgCdTe, matériau phare dans le domaine de la détection infrarouge, particulièrement dans les deux bandes de longueurs d'onde 3-5 µm et 8-12 µm. Plusieurs compagnies industrielles produisent et commercialisent des substrats de Cd_{0.96}Zn_{0.04}Te et la tendance est vers la fabrication de substrats de taille croissante afin de réaliser ensuite des réseaux plans focaux de détecteurs IR de très grande taille.
- Le composé binaire CdTe, et son alliage CdZnTe avec de faibles concentrations de zinc, est actuellement l'objet de recherches intensives dans le domaine de la détection nucléaire pour laquelle il présente un énorme potentiel, particulièrement pour des applications médicales, tant en détection de rayons X, avec des applications en radiographie médicale, qu'en détection gamma, avec des applications en gammagraphie médicale (gamma-caméra). La rapidité très supérieure de détection du semi-coriducteur CdTe vis-à-vis des détecteurs à scintillation actuels permet une imagerie en temps réel, très avantageuse pour l'observation d'organes en mouvement comme le coeur. De plus, la détection avec CdTe s'opère à température ambiante et non à la température de l'azote liquide comme pour les détecteurs à scintillation, d'où un moindre coût de fonctionnement et un allègement très substantiel des équipements, et la possibilité de réaliser des équipements mobiles.

Tant les applications de substrats d'épitaxie, que les applications relatives à la détection nucléaire nécessitent impérativement l'utilisation de monocristaux, jusqu'à présent très difficiles à préparer. La difficulté de réalisation de monocristaux freine actuellement le développement de ces applications. C'est pourquoi des efforts considérables sont consacrés depuis une quarantaine d'années pour préparer les monocristaux de CdTe.

Les techniques de croissance de monocristaux de CdTe peuvent être brièvement rappelées. Elles sont divisées en plusieurs catégories :
- la croissance à partir d'un liquide, stoechiométrique ou non stoechiométrique, dont on a analysé plus loin en détail les limites;
- la croissance en phase vapeur, soit par sublimation soit par transport chimique. Ces techniques, dans lesquelles l'ionicité de la liaison CdTe a également une influence très négative, sont limitées par le caractère aléatoire d'obtention de monocristaux et par des vitesses de croissance très lentes, impropres à la croissance industrielle.

Etant donné son point de fusion de 1092°C, inférieur au point de ramollissement de la silice, la croissance en phase liquide reste néanmoins la plus utilisée pour CdTe, et c'est cette technique qui est essentiellement mise en oeuvre industriellement, dans ses variantes de Bridgman vertical, horizontal ou sous pression.

Mokri et al (J.Crystal Growth, Vol. 138 (1994) 168-174) divulguent un procédé d'obtention de grands cristaux de CdZnTe de haute pureté, Ce procédé fait appel à la transformation d'un bloc polycristallin en un bloc comportant des monocristaux selon un processus de recristallisation à l'état solide.

Zhu et al. (J. Crystal Growth, Vol. 208 (2000) 264-268) obtiennent un monocristal de Cd_{0.96}Zn_{0.04}Te d'un diamètre de 20 mm et d'une longueur de 45 mm selon la méthode de Bridgman en appliquant à la fois une rotation au creuset et une oscillation en température au matériau fondu.

La préparation de monocristaux de CdTe présente de nombreuses difficultés techniques dont certaines sont détaillées ci-dessous.

On connaît les phénomènes de pré- et post-transition, en dessous et au-dessus du point de fusion du CdTe, dans les deux états liquide et solide.. Les phénomènes de pré- et post-transition sont dus au caractère ionique de la liaison chimique Cd-Te. Ce caractère ionique rend les liquides CdTe fortement associés à proximité du point de fusion, ce qui conduit à la présence de particules hautement organisées influençant le processus de nucléation et la cinétique de croissance.

A l'état solide, et toujours à proximité du point de fusion, des transitions de phase, mentionnées par de nombreux auteurs, compliquent aussi singulièrement la cristallogenèse de CdTe en phase liquide.
De plus, les effets du champ de gravité terrestre provoquent des phénomènes de convection difficilement contrôlables. Pour y remédier, on peut avoir recours à des techniques de croissance des cristaux en micro- ou macro-gravité pour les procédés en phase liquide et en phase vapeur, dont le coût est évidemment prohibitif.

Dans les procédés de l'état de la technique, et en particulier dans les procédés d'obtention de cristaux de CdTe selon la méthode de BRIDGMAN, la réduction de l'influence des phénomènes de convection a été recherchée en faisant croître les cristaux en conditions de micro-gravité, notamment durant des voyages spatiaux en apesanteur, et en macro-gravité dans des centrifugeuses.

Les nombreux inconvénients techniques cités ci-dessus pour l'obtention d'un monocristal de CdTe ou de CdZnTe en phase liquide ou en phase vapeur ont été résolus selon l'invention.

II a été montré selon l'invention qu'un monocristal de CdTe ou de CdZnTe possédant une excellente structure monocristalline pouvait être obtenu selon un procédé réalisé en phase solide.

L'invention a pour objet un procédé d'obtention d'un monocristal de Cd₁₋ₓZnₓTe, dans lequel x est compris entre 0 et 0,2, caractérisé en ce qu'il comprend les étapes suivantes :
a) obtention d'un matériau source de Cd₁₋ₓZnₓTe de composition proche de celle correspondant à la sublimation congruente soit par cristallisation d'un liquide Cd₁₋ₓZnₓTe par la technique de Bridgman horizontal sous pression partielle de cadmium pour ajuster la stoechiométrie, soit par recuit d'un matériau Cd₁₋ₓZnₓTe pré-synthétisé à 800-900 °C dans une ampoule à capillaire d'extrémité maintenue à température ambiante.
b) obtention d'un bloc polycristallin de Cd₁₋ₓZnₓTe, dans lequel x est compris entre 0 et 0,2, par sublimation d'une charge source solide stoechiométrique de Cd₁₋ₓZnₓTe dans une enceinte close à une température de la zone de l'enceinte dans laquelle la charge source est localisée comprise entre 900°C et 1000°C, la différence de température *ΔT* entre la zone de la charge source et la zone de dépôt du cristal étant comprise entre 30°C et 50°C et la surface de condensation étant soumise à une fluctuation sinusoïdale de température d'amplitude de l'ordre de 10°C et de période d'environ 20 minutes;
c) obtention du monocristal de Cd₁₋ₓZnₓTe par recristallisation du bloc polycristallin obtenu à l'étape b) par recuit en conditions isothermes sous une pression partielle de Cd comprise entre 4.10⁵ et 6.10⁵ Pa et à une température comprise entre 1000°C et 1060°C pendant une durée comprise entre 50 et 200 heures

Les symboles « Cd », « Te » et « Zn » représentent respectivement les atomes de cadmium, de tellure et de zinc.

Le procédé d'obtention d'un monocristal de Cd₁₋ₓZnₓTe est réalisé à une température inférieure au point de fusion de l'alliage.

Dans ces conditions de température, on n'observe pas les phénomènes de transitions de phases qui ont lieu pendant la mise en oeuvre des procédés de croissance des blocs cristallins en phase liquide décrits dans l'état de la technique

De plus, les conditions du procédé ci-dessus permettent la croissance de cristaux pratiquement stoechiométriques, contrairement aux procédés conventionnels dans lesquels l'ajustement est plus délicat. En effet, la matériau source utilisé pour l'étape de sublimation est préparé de façon à ce que sa composition permette une sublimation congruente, et donc une vitesse de transport élevée, c'est-à-dire avec une composition proche de la stoechiométrie.

Un autre avantage technique déterminant du procédé selon l'invention est que ce procédé permet de s'affranchir des effets du champ de gravité terrestre, qui provoque des phénomènes de convection non contrôlés.

Selon un premier mode de réalisation préféré du procédé ci-dessus, la valeur de x dans la formule Cd₁₋ₓZnₓTe est égale à zéro et le monocristal obtenu est un monocristal de CdTe.

Selon un second mode de réalisation du procédé ci-dessus, la valeur de x, dans la formule Cd₁₋ₓZnₓTe est différente de zéro, et le monocristal obtenu est un monocristal d'alliage de CdZnTe.

Le paramètre x est avantageusement compris entre 0,005 et 0,05, de préférence entre 0,01 et 0,05 et est de manière tout à fait préférée de 0,04, notamment dans la perspective d'obtention de substrats d'épitaxie pour HgCdTe.

### Etape a) du procédé

Cette étape consiste en la réalisation d'un matériau source de composition proche de la stoechiométrie destiné à la seconde étape de sublimation. Selon le procédé, ce matériau source est obtenu par réaction des éléments Cd et Te, et facultativement Zn en proportion stoechiométrique, puis ajustement de la stoechiométrie soit par cristallisation du bain fondu par la technique de Bridgman horizontal sous une pression partielle de cadmium permettant de contrôler l'écart à la stoechiométrie, soit par recuit du matériau synthétisé à une température comprise entre 800 et 900 °C dans une ampoule avec capillaire dans lequel se condensent les excès éventuels de l'un des éléments Cd ou Te.

### Etape b) du procédé

Cette étape consiste en la réalisation d'un lingot de CdTe polycristallin par sublimation d'une charge de composition proche de la stoechiométrie. Comme cela résulte directement des caractéristiques du procédé, il est établi un gradient de température dans une enceinte close, la surface de la charge source étant maintenue à une température suffisante pour provoquer la sublimation de Cd₁₋ₓZnₓTe et la zone de dépôt étant maintenue à une température inférieure.

La température de la zone de l'enceinte dans laquelle la charge source est localisée, qui est comprise entre 900°C et 1000°C, a été choisie de manière à être suffisamment élevée pour favoriser la sublimation à partir de la charge de source solide tout en restant inférieure au point de fusion de CdZnTe.

Avantageusement, la température de la zone de la charge source est comprise entre 940°C et 960°C, de préférence entre 945°C et 955°C. Elle est de manière tout à fait préférée d'environ 950°C.

Afin de réaliser la sublimation dans des conditions optimales, la différence de température Δ*T* entre la zone de la charge source et la zone de dépôt du cristal est comprise entre 30°C et 50°C.

Pour une valeur de différence de température *ΔT* inférieure à 30°C, on a pu observer une tendance à obtenir une structure à gros grains, moins favorable à l'étape ultérieure de recristallisation. On rappelle que l'énergie accumulée aux joints de grains constitue la force motrice de la recristallisation. Cette énergie est d'autant plus importante que les grains sont de plus petite taille et que, par conséquent, la surface des joints est plus importante..

Pour une valeur de différence de température Δ*T* supérieure à 50°C, on a pu observer l'apparition de pores ou trous dans les lingots obtenus.

Préférentiellement, la distance entre la surface d'évaporation de la charge de la source et la zone de dépôt du cristal est comprise entre 10 et 20 cm de manière tout à fait préférée entre 10 et 15 cm.

Les conditions optimales de sublimation pour former un bloc « polycristallin à l'étape b) du procédé sont atteintes grâce à une combinaison des paramètres Δ*T* et de la distance entre la surface de la charge source et la zone de dépôt.

Un paramètre avantageux du procédé selon l'étape b) est l'établissement d'une perturbation thermique à l'interface de croissance destinée à éviter une croissance excessive des grains en cours de dépôt. Cette perturbation thermique est réalisée par l'établissement d'un régime oscillatoire de la température de la zone de dépôt.

Sans introduction de cette perturbation thermique, les premiers cristallites déposés au moment de l'étape b) forment des nuclei qui croissent dans le temps pour former des structures mono cristallines, ce que l'on veut précisément éviter à ce stade du procédé. Afin d'obtenir un lingot ou bloc poly cristallin à l'issue de l'étape b) du procédé, on introduit une perturbation thermique qui provoque la formation continue de nouveaux nuclei dans le temps.

Préférentiellement, on crée une perturbation thermique sinusoïdale qui entraîne la formation de nouveaux nuclei à chaque cycle d'oscillation de la température.

De préférence, pour une valeur de AT de 30°C, on crée une variation de température de l'enceinte d'une amplitude de 10°C, de manière à faire varier la valeur ΔT de 20°c à 40°C, par exemple par une programmation adéquate des moyens de chauffage. La période de la sinusoïde peut varier, notamment en fonction des contraintes techniques liées aux moyens de chauffage ainsi qu'à l'inertie thermique de la charge elle-même et de la durée de l'étape b) d'obtention d'un lingot ou bloc poly cristallin. A titre illustratif, on préfère une période de la sinusoïde comprise entre 10 et 30 minutes, mieux entre 15 et 25 minutes, préférentiellement entre 18 et 22 minutes et de manière tout à fait préférée de 20 minutes.

Afin de réaliser le procédé selon l'invention dans des conditions optimales, en particulier dans des conditions optimales de la thermodynamique et de l'hydrodynamique, on a recours à une enceinte close de silice ayant la forme d'un tube présentant de préférence des extrémités plates. A l'étape b) du procédé, la géométrie de l'ampoule est importante. En particulier, la surface du bloc poly cristallin préparé détermine la surface du lingot ou bloc mono cristallin qui est le produit final du procédé. Ainsi, plus la surface du bloc poly cristallin est grande, plus la surface du lingot ou bloc mono cristallin final sera grande.

L'obtention d'un bloc poly cristallin de grande taille peut être avantageusement atteinte en utilisant une enceinte, par exemple une ampoule, présentant une extrémité plate, à partir de la surface de laquelle se forme le bloc poly cristallin. Dans le cas d'une enceinte cylindrique, telle qu'une ampoule, le diamètre de l'enceinte déterminera la surface du bloc poly cristallin formé à l'étape b) du procédé, et donc aussi la surface du bloc mono cristallin final.

Cette caractéristique géométrique de l'enceinte utilisée à l'étape b) du procédé est une distinction supplémentaire du procédé selon l'invention des procédés connus dans l'état de la technique, dans lesquels on choisit préférentiellement une enceinte a extrémité pointue, de manière à favoriser, par dépôt, la formation d'un seul nucleus à partir duquel doit se former un réseau mono cristallin.
Selon l'invention, il a été obtenu, à la fin de l'étape b), des blocs poly cristallins ayant jusqu'à 50,8 mm (jusqu'à 2 pouces) de diamètre.
La, durée de l'étape b) est classiquement de plusieurs heures, jusqu'à l'achèvement de la formation d'un lingot ou bloc poly cristallin. Elles est généralement comprise entre 5 heures et 48 heures, avantageusement entre 10 heures et 36 heures, de préférence entre 15 heures et 30 heures et de manière optimale de 24 heures.

### Etape c) du procédé

A la fin de l'étape b) du procédé, il est obtenu un bloc polycristallin de Cd₁₋ₓZnₓTe possédant la stoechiométrie recherchée entre les éléments Cd, Zn et Te,.

De plus, les blocs polycristallins obtenus à la fin de l'étape b) du procédé sont exempts de pores, encore désignés « microcavités », qui se retrouveraient après recristallisation dans les monocristaux et affecteraient significativement leur qualité et leurs propriétés.

A l'étape c) du procédé, le monocristal de Cd₁₋ₓZnₓTe est obtenu par recristallisation du bloc polycristallin obtenu à l'étape b).

Les recuits de recristallisation sont effectués de façon isotherme.

La pression partielle de Cd comprise entre 4.10⁵ et 6.10⁵ Pa permet d'éviter la décomposition du matériau.

La température de l'étape c), qui est comprise entre 1000°C et 1060°C, est à la fois suffisante pour obtenir la conversion d'un réseau polycristallin en un réseau monocristallin tout en restant inférieure à la température de fusion du CdTe ou du CdZnTe.

A une température inférieure à 1000°C, les temps de recuit peuvent devenir beaucoup trop longs et coûteux, la température étant un paramètre essentiel de la cinétique de croissance.

A une température supérieure à 1060°C, on s'approche trop du point de fusion et des pré-transitions de phase signalées dans la littérature.

La durée de l'étape c) est comprise entre 50 et 200 heures afin de permettre une conversion complète du réseau polycristallin en un réseau monocristallin.

La géométrie de l'enceinte dans laquelle on réalise l'étape c) du procédé n'est pas déterminante pour les résultats à atteindre. II ressort des caractéristiques du procédé que le lingot ou bloc mono cristallin est formé directement à partir du lingot ou bloc poly cristallin préparé à l'étape b), et qu'il suffit que l'enceinte utilisée à l'étape c) ait un volume qui puisse recevoir le bloc poly cristallin préparé à l'étape b).

De manière tout à fait préférée, l'enceinte close est une ampoule dont le diamètre inférieur est au plus de 50,8 mm (au plus de 2 pouces).

On a montré selon l'invention que l'étape c) de recristallisation pour l'obtention d'un monocristal n'était pas inhibée par la présence de zinc dans le CdTe, lorsque le zinc est présent dans le CdTe à des concentrations inférieures ou égales à 20% en atomes.
De plus; il a été montré selon l'invention que la concentration de zinc mesurée dans le matériau monocristal, après recristallisation, était égale à la concentration du zinc dans le matériau de la charge de source. Sans vouloir être lié par une quelconque théorie, le demandeur pense que cette caractéristique spécifique au procédé de l'invention indique que le phénomène de ségrégation du zinc dans le CdZnTe, qui est observé avec les procédés en phase liquide ou en phase gazeuse de l'état de la technique, n'a pas lieu lors de la mise en oeuvre du procédé de l'invention ou est significativement réduit.

L'absence de phénomène de ségrégation du zinc dans le CdTe lors de la mise en oeuvre du procédé de l'invention constitue un avantage technique important, du fait que la ségrégation du zinc, notamment.dans les techniques de croissance cristalline en phase liquide, constitue un inconvénient technique majeur limitant drastiquement les rendements de production des produits finaux, tels que les substrats et les détecteurs.

Ainsi, le procédé d'obtention d'un monocristal de Cd₁₋ₓZnₓTe selon l'invention peut être en outre caractérisé en ce que la charge source est obtenue selon la méthode suivante :
a) préparation d'une charge source de départ selon l'une des méthodes suivantes :
   (i) réaction de Cd et Te, et facultativement Zn, en quantités stoechiométriques, en phase liquide et à haute température;
   (ii) réaction de Cd et Te, et facultativement Zn, en quantités stoechiométriques en phase vapeur ;
b) ajustement de la stoechiométrie Cd/Te de la charge source de départ obtenue à l'étape a) selon l'une des méthodes suivantes :
   (iii) par recuit de la charge source de départ à une température comprise entre 800°C et 900°C dans une ampoule avec capillaire condensant les excès éventuels de l'un des éléments Cd et Te ;
   (iv) par cristallisation de la charge source de départ selon la méthode de Bridgman en enceinte horizontale, sous pression partielle de Cd (Horizontal Bridgman growth of large high quality Cd_{1-y}Zn_{y}Te crystals
      P. BRUNET, A. KATTY, D. SCHNEIDER, A. TROMSON-CARLI, R. TRIBOULET, Mater. Sci. Eng. B16 (1993) 44)

Le monocristal de Cd₁₋ₓZnₓTe, qui constitue le produit final du procédé selon l'invention est complètement monocristallin, ce qui est rarement obtenu, et en tout cas pas de façon reproductible, avec l'un quelconque des procédés en phase vapeur ou en phase liquide décrits dans l'état de la technique.

En particulier, le procédé selon l'invention a déjà permis d'obtenir des monocristaux de grande surface, jusqu'à 4cm². Des monocristaux de 20 cm² sont actuellement en préparation.

Pour les monocristaux de CdTe, il a été montré selon l'invention que ces monocristaux présentent des lignes de pseudo-Kikuchi résolues jusqu'au 4^{ème} ordre. Les lignes de pseudo-kikuchi sont des diagrammes d'étectrons canalisés en microscopie électronique à balayage.

Il a également été montré que les monocristaux de CdTe obtenus selon le procédé de l'invention possédaient en double diffraction de rayons X des largeurs de Rocking-curve à mi-hauteur inférieures à 30 secondes d'arc, ce qui démontre leur excellente qualité cristallographique.

De plus, les monocristaux de CdTe ou de CdZnTe obtenus de manière reproductible selon le procédé de l'invention, possèdent un axe de croissance selon la direction (111).

Cette caractéristique est particulièrement avantageuse pour la production de substrats d'épitaxie, dont les surfaces (111) sont préférentiellement utilisées industriellement.

Les monocristaux de CdTe présentent des plans (111) polaires constitués uniquement d'atomes de tellure et des plans constitués uniquement d'atomes de cadmium, ce qui facilite considérablement l'opération de découpe des cristaux de manière à obtenir des tranches de cristal (désignées aussi « wafers ») découpées selon l'axe de croissance du lingot. Les plans tellure et les plans cadnium, qui sont les faces « A » et « B » de la tranche du cristal sont perpendiculaires à l'axe <111>.

Le procédé produit aussi un monocristal de Cd₁₋ₓZnₓTe, dans lequel x est compris entre 0 et 0,2, caractérisé en ce que :
(i) il présente des lignes de pseudo-Kikuchi résolues jusqu'au quatrième ordre ;
(ii) il présente des largeurs de rocking-curve à mi-hauteur inférieures à 30 secondes d'arc.

Pour les diverses utilisations d'un monocristal Cd₁₋ₓZnₓTe l'homme du métier pourra avantageusement se référer à l'ouvrage de K. Zanio (Cité plus haut)

L'invention est en outre illustrée, sans pour autant être limitée, par les exemples suivants.

### EXEMPLES

### EXEMPLE 1 : Préparation d'un monocristal de CdTe selon un procédé conforme à l'invention.

### A. MATERIELS ET METHODES

### A.1 Préparation d'une charge source de CdTe.

La charge source est prélevée dans un lingot de CdTe issu de la technique de Bridgman horizontal sous contrôle de la pression partielle de cadmium pour ajuster la stoechiométrie. La pression partielle de cadmium correspond à un point froid de l'enceinte de 780 °C. Ce protocole expérimental est décrit dans l'article suivant ::
Horizontal Bridgman growth of large high quality Cd_{1-y}Zn_{y}Te crystals
   P. BRUNET, A. KATTY, D. SCHNEIDER, A. TROMSON-CARLI, R. TRIBOULET, Mater. Sci. Eng. B16 (1993) 44

Alternativement, la charge peut être préparée par Bridgman vertical, avec ou sans contrôle de la pression partielle de cadmium, puis recuite à 900 °C dans une ampoule à capillaire dont l'extrémité est maintenue à la température ambiante pour ajuster la composition à une valeur correspondant à la sublimation congruente.

### A.2 Préparation d'un bloc polycristallin de CdTe

Le matériau source, typiquement 60 g de CdTe, est chargé dans une ampoule de 2 cm de diamètre intérieur scellée ensuite- sous vide secondaire. L'ampoule, graphitée aux deux extrémités, est disposée dans un réacteur à huit zones de chauffe permettant d'obtenir à volonté un profil thermique tel que la charge se trouve à 950 °C, le point froid à 12 cm de cette charge à 920 °C. Une oscillation thermique d'amplitude 10 °C est provoquée par les régulateurs/programmateurs Eurotherm 906P au niveau de l'interface de croissance. La période de cette oscillation est d'environ 20 minutes. L'ampoule est maintenue fixe dans ce réacteur pendant 24 h, durée suffisante pour que l'intégralité de la charge soit transportée au point froid.

### A.3 Obtention du monocristal de CdTe.

Après extraction de l'ampoule précédente, extraction rendue très aisée par la présence de graphite sur les parois de l'ampoule, le lingot polycristallin est introduit dans une ampoule elle-même graphitée. Cette ampoule, après scellement sous vide secondaire, est disposée dans la partie isotherme d'un four horizontal à 1060°C. L'ampoule contient également une quantité de cadmium correspondant à une pression partielle de 5×10⁵ Pa à 1060 °C pour le volume considéré. Cette quantité de cadmium est déterminée en prenant en compte la formule des gaz parfaits, PV = nRT. L'ampoule est maintenue dans ce plateau isotherme pendant 120 h.

### B. RESULTATS :

### Analyse des caractéristiques du monocristal obtenu.

L'intégralité du lingot soumis à recristallisation s'avère être un monocristal. Une largeur de rocking-curve à mi-hauteur, en double diffraction de rayons X, de 30 arc seconde et des lignes de pseudo Kikuchi, en canalisation d'électrons dans un microscope électronique à balayage, témoignent de son excellente qualité cristallographique. De plus, le matériau source obtenu après l'étape b) de sublimation présente une texture, analysée en EBSD (electron back scattering diffraction) telle que l'orientation générale de l'axe de croissance des cristaux est proche de (111) à quelques degrés près.
Cette orientation est conservée dans les cristaux obtenus après l'étape c) de recristallisation. La grande face des cristaux obtenus est donc le plan (111), ce qui est très favorable dans la perspective de découpe de substrats d'épitaxie de CdHgTe pour lesquels c'est très précisément cette orientation qui est requise.

## Revendications

1. Procédé d'obtention d'un monocristal de Cd₁₋ₓZnₓTe, dans lequel x est compris entre 0 et 0,2 **caractérisé en ce qu'**il comprend les étapes suivantes :
a) obtention d'un matériau source de Cd₁₋ₓZnₓTe de composition proche de celle correspondant à la sublimation congruente, soit par cristallisation d'un liquide Cd₁₋ₓZnₓTe par la technique de Bridgman horizontal sous pression partielle de cadmium pour ajuster la stoechiométrie, soit par recuit d'un matériau Cd₁₋ₓZnₓTe pré-synthétisé à 800-900°C dans une ampoule à capillaire d'extrémité maintenue à température ambiante ;
b) obtention d'un bloc polycristallin de Cd₁₋ₓZnₓTe, dans lequel x est compris entre 0 et 0,2, par sublimation d'une charge source solide stoechiométrique de Cd₁₋ₓZnₓTe dans une enceinte close à une température de la zone de l'enceinte dans laquelle la charge source est ' localisée comprise entre 900°C et 1000°C, la différence de température ΔT entre la zone de la charge source et la zone de dépôt du cristal étant comprise entre 30°C et 50°C et la surface de condensation étant soumise à une fluctuation sinusoïdale de température d'amplitude de l'ordre de 10°C et de période d'environ 20 minutes ;
c) obtention du monocristal de Cd₁₋ₓZnₓTe par recristallisation du bloc polycristallin obtenu à l'étape b) par recuit en conditions isothermes sous une pression partielle de Cd comprise entre 4.10⁵ et 6.10⁵ Pa et à une température comprise entre 1000°C et 1060°C pendant une durée comprise entre 50 et 200 heures.

2. Procédé selon la revendication 1, **caractérisé en ce que** le monocristal de Cd₁₋ₓZnₓTe est un monocristal de CdTe, lorsque x = 0.

3. Procédé selon l'une des revendications 1 à 2, **caractérisé en ce qu'**à l'étap.e b), la température de la zone de la charge source est comprise entre 940°C et 960°C, de préférence entre 945°C et 955°C et est de manière tout à fait préférée d'environ 950°C.

4. Procédé selon l'une des revendications 1 à 3, **caractérisé en ce qu'**à l'étape b) la distance entre la surface d'évaporation de la charge de la source et la zone de dépôt est comprise entre 10. et 20 cm, de préférence entre 12 et 15 cm.

5. Procédé selon l'une des revendications 1 à 4, **caractérisé en ce que** la charge source est obtenue selon la méthode suivante :
a) préparation d'une charge source de départ selon l'une des méthodes suivantes :
(i) réaction de Cd et Te, et facultativement Zn, en quantités stoechiométriques en phase liquide et à haute température :
(ii) réaction de Cd et Te, et facultativement Zn, en quantités stoechiométriques en phase vapeur ;
b) ajustement de la stoechiométrie Cd/Te de la charge source de départ obtenue à l'étape a) selon l'une des méthodes suivantes :
(iii) par recuit de la charge source de départ à une température comprise entre 800°C et 900°C dans une ampoule avec capillaire condensant les excès éventuels de l'un des éléments Cd et Te :
(iv) par cristallisation de la charge source de départ selon la méthode de Bridgman en enceinte horizontale, sous pression partielle de Cd permettant d'ajuster la stoechiométrie.

## Claims

1. Method for obtaining a Cd₁₋ₓZnₓTe single crystal, in which x is between 0 and 0.2, **characterized in that** it comprises the following steps:
a) obtaining a Cd₁₋ₓZnₓTe source material having a composition close to that corresponding to congruent sublimation, either by crystallising a Cd₁₋ₓZnₓTe liquid by the horizontal Bridgman method under partial cadmium pressure for stoichiometry adjustment, or by annealing a Cd₁₋ₓZnₓTe material, which has been pre-synthesised at 800-900 °C, in an ampoule having an end capillary maintained at ambient temperature;
b) obtaining a polycrystalline block of Cd₁₋ₓZnₓTe, in which x is between 0 and 0.2, by sublimation of a stoichiometric solid Cd₁₋ₓZnₓTe source material in a sealed chamber, the temperature of the chamber zone in which the source material is located being between 900 °C and 1000 °C, the temperature difference ΔT between the source material zone and the crystal deposition zone being between 30 °C and 50 °C, and the condensation surface being subjected to a sinusoidal temperature fluctuation having an amplitude of about 10 °C and a period of approximately 20 minutes.
c) obtaining a Cd₁₋ₓZnₓTe single crystal by re-crystallising the polycrystalline block obtained in step b), by annealing under isothermal conditions under a partial Cd pressure between 4 x 10⁵ and 6 x 10⁵ Pa and at a temperature between 1000 °C and 1060 °C for a time of between 50 and 200 hours.

2. Method according to claim 1, **characterised in that** the Cd₁₋ₓZnₓTe single crystal is a CdTe single crystal, when x = 0.

3. Method according to either claim 1 or claim 2, **characterised in that** in step b), the temperature of the source material zone is between 940 °C and 960 °C, preferably between 945 °C and 955 °C, and is most preferably approximately 950 °C.

4. Method according to any one of claims 1 to 3, **characterised in that** in step b), the distance between the source material evaporation surface and the deposition zone is between 10 and 20 cm, preferably between 12 and 15 cm.

5. Method according to any one of claims 1 to 4, **characterised in that** the source material is obtained by the following method:
a) preparing a starting source material by one of the following methods:
i) reacting Cd and Te, and optionally Zn, in stoichiometric amounts, in the liquid phase and at high temperature;
ii) reacting Cd and Te, and optionally Zn, in stoichiometric amounts, in the vapour phase;
b) adjusting the Cd/Te stoichiometry of the starting source material obtained in step a), by one of the following methods:
iii) annealing the starting source material at a temperature between 800 °C and 900 °C in an ampoule having a capillary which condenses any excesses of either of the elements Cd and Te;
iv) crystallising the starting source material by the horizontal Bridgman method under partial Cd pressure to allow stoichiometry adjustment.

## Patentansprüche

1. Verfahren zum Erhalt eines Cd1-xZnxTe-Monokristalls, worin x zwischen 0 und 0,2 liegt, **dadurch gekennzeichnet, dass** es die folgenden Schritte umfasst:
a) Erhalt eines Cd1-xZnxTe-Ausgangsmaterials mit einer Zusammensetzung, die der nahe ist, die einer kongruenten Sublimierung entspricht, sei es durch Kristallisation einer Cd1-xZnxTe-Flüssigkeit mittels der horizontalen Bridgman-Technik unter partiellem Cadiumdruck, um die Stöchiometrie anzupassen, sei es durch Glühen eines Cdl-xZnxTe-Materials, das bei 800-900°C in einer Am-pulle mit einer Kapillare an deren Ende vorsynthetisiert wurde, die bei Umgebungstemperatur gehalten wurde;
b) Erhalt eines polykristallinen Cdl-xZnxTe-Blocks, in dem x zwischen 0 und 0,2 liegt, durch Sublimation eines stöchiometrischen festen Cdl-xZnxTe-Ausgangsmaterials in einer versiegelten Kammer bei einer Temperatur der Zo-ne der Kammer, in der sich das Ausgangsmaterial zwischen 900°C und 1000°C befindet, wobei der Temperaturunterschied ?T zwischen der Zone des Ausgangsmaterials und der Zone der Kristallablagerung zwischen 30°C und 50°C liegt und die Kondensationsoberfläche einer sinusförmigen Temperaturfluktuation mit einer Amplitude in einer Größenordnung von 10°C und einer Periode von ungefähr 20 min unterworfen wird;
c) Erhalt eines Cdl-xZnxTe-Monokristalls durch Rekristallisieren des in Schritt b) erhaltenen polykristallinen Blocks durch Glühen unter isothermen Bedingun-gen unter einem zwischen 4.105 und 6.105 Pa liegenden Cd-Partialdruck und einer zwischen 1000°C und 1060°C liegenden Temperatur für eine Dauer zwi-schen 50 bis 200 Stunden.

2. Verfahren nach Anspruch 1, **dadurch gekennzeichnet, dass** das Cdl-xZnxTe-Monokristall ein CdTe-Monokristall ist, wenn x=0 ist.

3. Verfahren nach einem der Ansprüche 1 bis 2, **dadurch gekennzeichnet, dass** in Schritt b) die Temperatur der Zone des Ausgangsmaterials zwischen 940°C und 960°C liegt, bevorzugt zwischen 945°C und 955°C und besonders bevorzugt bei ungefähr 950°C.

4. Verfahren nach einem der Ansprüche 1 bis 3, **dadurch gekennzeichnet, dass** in Schritt b) der Abstand zwischen der Verdampfungsoberfläche der Zuführung des Ausgangs-materials und der Ablagerungszone zwischen 10 und 20 cm liegt, bevorzugt zwischen 12 und 15 cm.

5. Verfahren nach einem der Ansprüche 1 bis 4, **dadurch gekennzeichnet, dass** das Aus-gangsmaterial nach dem folgenden Verfahren erhalten wird:
a) Herstellen des anfänglichen Ausgangsmaterials nach einem der folgenden Verfahren:
(i) Umsetzen von Cd und Te und optional Zn in stöchiometrischen Mengen ein flüssiger Phase und bei hoher Temperatur;
(ii) Umsetzen von Cd und Te und optional Zn in stöchiometrischen Mengen in der Dampfphase;
b) Anpassen der Cd/Te-Stöchiometrie in dem in Schritt a) erhaltenen anfängli-chen Ausgangsmaterial nach einem der folgenden Verfahren:
(iii) Glühen des anfänglichen Ausgangsmaterials bei einer zwischen 800°C und 900°C liegenden Temperatur in einer Ampulle mit einer Kapillare; wobei etwaige Überschüsse eines der Elemente Cd und Te kondensieren,
(iv) Kristallisation des anfänglichen Ausgangsmaterials unter Ver-wenden der Bridgman-Technik in einer horizontalen Kammer unter Cd-Partialdruck, wobei die Anpassung der Stöchiometrie ermöglicht wird.
